# EUROPÄISCHE PATENTSCHRIFT

(11) **EP 0 280 126 B1**
(45) Veröffentlichungstag und Bekanntmachung des Hinweises auf die Patenterteilung: **08.06.1994**
(21) Anmeldenummer: 88102048.1
(22) Anmeldetag: 12.02.1988
(51) Int. Cl.: H03K 23/00, H03K 23/66, H03K 23/68

(54) **Programmierbarer Frequenzteiler zur Erzeugung eines niederfrequenten Signals aus einem hochfrequenten Signal**
Programmable frequency divider for generating a low-frequency signal from a high-frequency signal
Diviseur de fréquence programmable pour obtenir un signal basse fréquence à partir d'un signal haute fréquence

(30) Priorität: 21.02.1987 DE 3705629
(43) Veröffentlichungstag der Anmeldung: 31.08.1988
(73) Patentinhaber: Deutsche Thomson-Brandt GmbH, 78003 Villingen-Schwenningen (DE)
(72) Erfinder: Mahr, Peter, D-7819 Denzlingen (DE)

(56) Entgegenhaltungen:
- EP-A- 0 174 880
- DE-A- 3 410 800
- DE-A- 3 503 182
- SIEMENS Datenbuch 1974/75 Band 1 "Digitale Schaltungen MOS"
- D. Nührmann, "Impuls- und Videotechnik, Infrarot- Systeme, digitale Signalverarbeitung und NF-Technik", Francis' Verlag GmbH München, 1984, Seiten 157 bis 160 und 166 bis 169.
- U. Tietze, Ch. Schenk, "Halbleiter-Schaltungs- technik", fünfte Auflage, Springer Verlag Berlin Heidelberg New York Seiten 505 bis 506

## Beschreibung

Die Erfindung betrifft einen programmierbaren Frequenzteiler für ganzzahlige Teilerverhältnisse nach dem Oberbegriff des Anspruchs 1 sowie einen programmierbaren Frequenzteiler für ganz- und gebrochenzahlige Teilerverhältnisse nach dem Oberbegriff des Anspruchs 2.

Ein solcher Freuenzteiler ist bekannt aus D. Nührmann, "Impuls- und Videotechnik, Infrarot-Systeme, digitale Signalverarbeitung und NF-Technik, Franzis Verlag GmbH München, 1984, Seiten 157 - 160 und 166 - 169. Bei diesem bekannten Frequenzteiler ist dabei der Ausgang des Flip-Flops mit dem Steuereingang der ersten Teilerschaltung über ein einen ganzzahligen Anteil des Teilerverhältnisses veränderndes Logikelement verbunden.

Aus der DE-OS 35 03 182 ist ebenfalls ein programmierbarer Frequenzteiler mit den eingangs genannten Merkmalen bekannt. Dieser bekannte Frequenzteiler ermöglicht es, Teilerverhältnisse zwischen dem Wert 1,0 und 2,0 vorzugeben. Zur Erzielung des gewünschten Teilerverhältnisses werden vom Ausgang einer ersten Teilerschaltung sowie von den Ausgängen einer zweiten Teilerschaltung Nadelimpulse gewonnen und diese einem statischen Eingang eines Flip-Flops zugeführt. Der andere statische Eingang des Flip-Flops erhält hochfrequente Eingangssignale, wie sie auch an den Eingang der ersten Teilerschaltung gelangen. Der Eingang der ersten Teilerschaltung ist sowohl Eingang für die hochfrequenten Signale als auch Steuereingang zur Vorgabe des Teilerverhältnisses. Das Teilerverhältnis wird dann so eingestellt, daß durch entsprechendes Setzen des Flip-Flops der Eingang der ersten Teilerschaltung entsprechend dem gewünschten Verhältnis abwechselnd für hochfrequente Signale freigegeben und gesperrt wird.

Der bekannte programmierbare Frequenzteiler wird nicht allen Anwendungsfällen gerecht. Das ist dann der Fall, wenn ein sehr großer Variationsbereich des Teilerverhältnisses gefordert wird. Ein solcher Anwendungsfall liegt z.B. bei einem magnetischen oder optischen Aufzeichnungsgerät vor, bei dem ein Schreiblesekopf nach einer vorgegebenen Funktion schnell und präzise an bestimmte Spuren oder Speicherplätze herangeführt werden soll.

Um neben den großen Variationsbereich eine hohe Auflösung entsprechend einem ganz- und gebrochenzahligen Teilerverhältnis zu erhalten, könnte auch von einer höheren Ausgangsfrequenz ausgegangen und das Teilerverhältnis dann auf ganzzahlige Werte beschränkt werden. Eine solche Lösung hat jedoch Nachteile, da die dann benötigten hohen Ausgangsfrequenzen Störungen in einem Nutzsignalbereich hervorrufen könnten oder die erforderlichen Bauelemente für eine schnelle Signalverarbeitung ausgelegt sein müßten, was ebenfalls mit der Erzeugung von Störanteilen bei der Signalverarbeitung verbunden wäre.

Der Erfindung liegt die Aufgabe zugrunde, einen programmierbaren Frequenzteiler für ganz- und/oder gebrochenzahlige Teilerverhältnisse zu schaffen, welcher einen hohen Variationsbereich des Teilerverhältnisses sowie eine hohe Auflösung bei den gebrochenzahligen Anteilen des Teilerverhältnisses bietet.

Diese Aufgabe wird bei einem programmierbaren Frequenzteiler nach dem Oberbegriff des Anspruchs 1 bzw. 2 durch die im kennzeichnenden Teil angegebenen Merkmale gelöst.

Durch die Benutzung eines Flip-Flops mit dynamischem Eingang läßt sich die Ansteuerung des Flip-Flops von der hochfrequenten Eingangsseite der ersten Teilerschaltung entkoppeln. Diese Maßnahme ermöglicht, das Teilerverhältnis auf andere Weise zu ändern, als durch zeitweise Unterdrückung des hochfrequenten Eingangssignals. Dadurch lassen sich abrupte Frequenzänderungen, die erst im Mittel über einen längeren Zeitraum betrachtet, einem gebrochenzahligen Teilerverhältnis entsprechen würden, vermeiden, zum anderen wird ein kontinuierlich in sehr feien Abstufungen veränderbarer großer Variationsbereich des Teilerverhältnisses ermöglicht.

Dies geschieht, indem der ganzzahlige Anteil in an sich bekannter Weise über den Steuereingang der ersten Teilerschaltung vorgegeben wird und der gebrochenzahlige Anteil durch Hin- und Herschalten des Teilerverhältnisses zwischen zwei Werten gewonnen wird. Die niedrige Ausgangfrequenz pendelt also nur zwischen zwei, vorzugsweise um den Wert "eins" differierenden Werten hin und her. Der Mittelwert stellt sich so über eine Pendelperiode ein. Dieses Hin- und Herpendeln ist für die meisten praktischen Anwendungsfälle völlig ausreichend, da im Falle des Antriebs massebehafteter Systeme ein Ausgleich über die Trägheit herbeigeführt wird oder aber eine Toleranzbandbreite vorhanden ist, welche im Kurzzeitbereich durch das Pendeln der Ausgangsfrequenzen nicht überschritten wird.

In der Zeichnung zeigen:

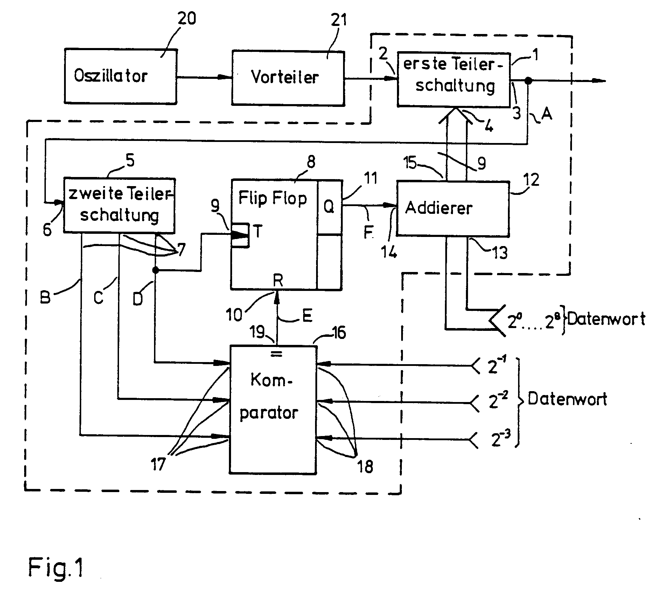

- Fig. 1: ein Blockschaltbild des erfindungsgemäßen programmmierbaren Frequenzteilers,
- Fig. 2: Impulsdiagramme bei einem Frequenzteiler gemäß Fig. 1
Im Ausführungsbeispiel dient der programmierbare Frequenzteiler zur Ansteuerung eines Motors für die Spurführung eines Schreiblesekopfes eines Datenaufzeichnungsgerätes.

Der programmierbare Frequenzteiler ist dabei durch die im gestrichelten Block vorhanden Baugruppen gebildet. Im einzelnen umfaßt er eine erste Teilerschaltung 1, eine zweite Teilerschaltung 5, ein dynamisches d.h. einflankengetriggertes Flip-Flop 8, einen Addierer 12 und einen Komparator 16. Die erste Teilerschaltung erhält ein Signal hoher Frequenz an ihren Eingang 2 über einen Vorteiler 21, der von einem Oszillator 20 gespeist wird. An einem Ausgang 3 der ersten Teilerschaltung 1 ist ein Signal einer heruntergeteilten, niedrigen Frequenz abgreifbar. Über einen Steuereingang 4 wird der ersten Teilerschaltung 1 das Teilerverhältnis in Form eines Datenwortes vorgegeben. Das Datenwort umfaßt insgesamt 12 Bit, von denen die 9 Bit höher Wertigkeit einen ganzzahligen Anteil des Teilerverhältnisses ausmachen. Das für die erste Teilerschaltung 1 bestimmte Datenwort wird an einen ersten Eingang 13 des Addierers 12 angelegt und gelangt über einen Ausgang 15 zum Steuereingang 4 der ersten Teilerschaltung.

Vom Ausgang 3 der ersten Teilerschaltung 1 führt eine Leitung A zu einem Eingang 6 der zweiten Teilerschaltung 5. Ein Ausgang 7 der zweiten Teilerschaltung 5 umfaßt drei Leitungen B, C, D, die vollständig zu einem ersten Eingang 17 des Komparators 16 geführt sind. Die Leitung D, welche die höchstwertige Stelle am Ausgang 7 der zweiten Teilerschaltung 5 darstellt, ist außerdem mit einem dynamischen Eingang 9 des Flip-Flops 8 verbunden. Ein Ausgang 11 des Flip-Flops 8 führt über eine Leitung F zu einem zweiten Eingang 14 des Addierers 12. Die Leitung F entspricht dabei der niedrigwertigen Stelle am zweiten Eingang 14 des Addierers 12.

Über einen zweiten Eingang 18 des Komparators 16 ist ein drei Bit umfassendes Datenwort vorgebbar, welches dem gebrochenzahligen Anteil des Teilerverhältnisses entspricht. Ein Paritätsausgang 19 ist über eine Leitung E mit einem statischen Eingang 10 des Flip-Flops 8 verbunden.

Mit dem dargestellten programmierbaren Frequenzteiler kann durch entsprechende Vorgabe des Teilerverhältnisses aus dem konstanten Signal einer hohen Frequenz am Eingang 2 ein Signal einer gewünschten niedrigeren Frequenz am Ausgang 3 erzeugt werden. Dazu werden an die Eingänge 13 und 18 entsprechende Datenworte angelegt. Zunächst einmal soll davon ausgegangen werden, daß ein ganzzahliges Teilerverhältnis gewünscht ist. In diesem Fall reicht es aus, nur das Datenwort am Eingang 13 entsprechend vorzugeben, und den Eingang 18 auf allen Stellen zu Null zu setzen. Die erste Teilerschaltung 1 übernimmt dann vollständig die Frequenzteilung, während die mit 5, 8, 12 und 16 Baugruppen praktisch außer Betrieb sind.

Soll nun ein gebrochenzahliges Teilerverhältnis gewählt werden, muß auch ein Datenwort an den zweiten Eingang 18 des Komparators 16 gelegt werden. Durch die Einspeisung des Signals am Ausgang 3 der ersten Teilerschaltung in den Eingang 6 der zweiten Teilerschaltung 5 wird nach jeweils acht Schwingungszügen der dynamische Eingang 9 des Flip-Flops 8 über die Leitung D getriggert und das Ausgangssignal des Flip-Flops 8 beaufschlagt daraufhin den zweiten Eingang 14 des Addierers 12 über die Leitung F mit einem Übertragssignal. Am Ausgang 15 des Addierers 12 erscheint daraufhin das Datenwort um den Wert "eins" erhöht. Das Teilerverhältnis der ersten Teilerschaltung 1 wird auf diese Weise geändert.

Nachdem nun so viele Schwingungszüge abgewartet wurden, wie dem Datenwort am Eingang 18 des Komparators 16 entsprechen, also bei Erreichen der Übereinstimmung der Signale am ersten Eingang 17 und am zweiten Eingang 18, erscheint am Paritätsausgang 19 ein Paritätssignal, das über die Leitung E auf den statischen Eingang 10 des Flip-Flops 8 gelangt und dieses zurücksetzt. Das Übertragssignal F verschwindet und am Steuereingang 4 der ersten Teilerschaltung liegt wieder das Datenwort in identischer Weise wie am ersten Eingang 13 des Addierers 12 an.

Dieser Vorgang wiederholt sich nun zyklisch, so daß das Teilerverhältnis der ersten Teilerschaltung 1 zwischen zwei Werten hin- und herpendelt und sich somit ein Mittelwert ergibt, der dem gesamten vorgegebenen Teilerverhältnis aus den Datenworten am Eingang 13 und am Eingang 18 spricht.

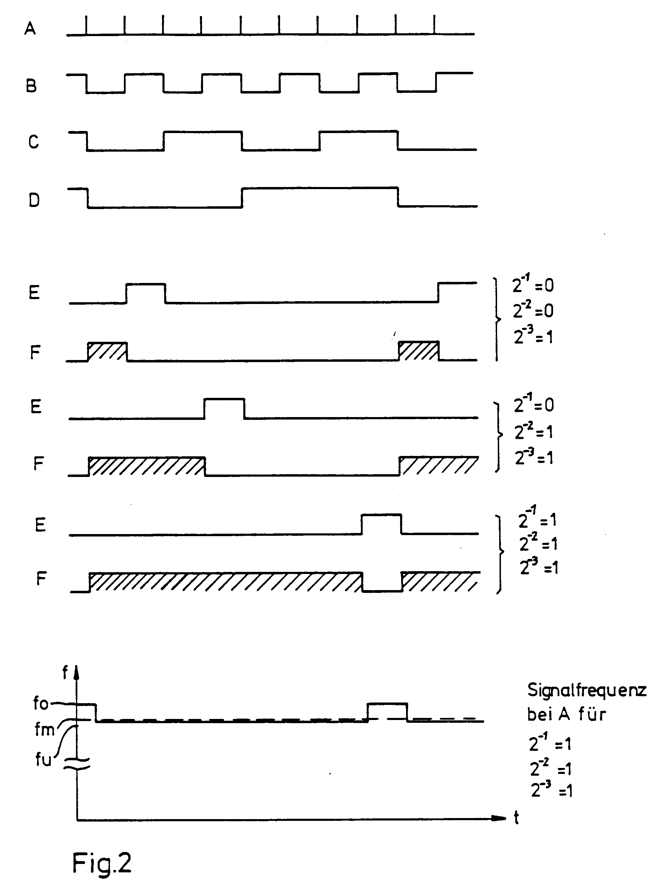

Die Wirkungsweise des programmierbaren Frequenzteilers nach der Erfindung läßt sich auch an Hand eines Impulsdiagramms erläutern, wie es in Fig. 2 dargestellt ist. Vorab sei angemerkt, daß der Zeitmaßstab dieser Darstellung verzerrt dargestellt ist, denn die Periodendauer der dargestellten Schwingungszüge verändert sich bei Änderung des Teilerverhältnisses.

In den oberen vier Zeilen sind die Signale auf den Leitungen A, B, C und D dargestellt. Es wird gerade davon ausgegangen, daß die Leitungen B, C und D am Ausgang 7 der zweiten Teilerschaltung 5 gerade auf 1-Potential liegen und beim Eintreffen des nächsten Impulses gemeinsam auf 0-Potential umschalten. Da das Flip-Flop 8 durch die negative Flanke auf der Leitung D getriggert wird, führt dieser Vorgang zu einem 1-Potential auf der Leitung F. Im mittleren Teil der Darstellung sind die Signale auf den Leitungen E und F für drei verschiedene Datenworte am Eingang 18 des Komparators 16 angegeben. Es handelt sich hierbei 1. um das Datenwort 001, 2. um das Datenwort 011 und 3. um das Datenwort 111. Entsprechend dem vorgegebenen Datenwort am Eingang 18 werden dieselben Anzahlen von Schwingungszügen auf der Leitung A abgewartet, bis der Komparator 16 über die Leitung E das Flip-Flop 8 setzt und das Potential auf der Leitung F auf Null zurückkehrt.

Wie die Darstellungen für die drei verschiedenen Datenworte erkennen lassen, ergibt sich auf diese Weise ein unterschiedliches Verhältnis der Zeitdauer der Potentiale auf der Leitung F. Entsprechend wird auch das Teilerverhältnis der ersten Teilerschaltung 1 verändert. Die Auswirkungen dieser Maßnahme auf die Frequenz des Signals am Ausgang 3 der ersten Teilerschaltung ist für den dritten Fall, also für den Fall des Datenwortes 111 am Eingang 18 dargestellt und zwar sind hier die verschiedenen Frequenzen über der Zeitachse t aufgetragen.

Durch den Potentialwechsel auf der Leitung F wird zwischen den Frequenzen fₒ und fᵤ hin- und hergeschaltet. Es stellt sich so ein Mittelwert fₘ ein, der sich durch das gebrochenzahlige Teilerverhältnis in Bezug auf die Eingangsfrequenz ergibt.

Die mit 5, 8, 12 und 16 bezeichneten Baugruppen brauchen nicht diskret vorhanden zu sein. Es ist auch möglich, hierfür einen Rechner vorzusehen und die Funktionen entsprechend programmgesteuert ausführen zu lassen. Dies ist besonders dann zweckmäßig, wenn für die Bestimmung des Teilerverhältnisses, z.B. für die Steuerung eines Motors ohnehin ein Rechner erforderlich ist. In diesem Falle werden die am Ausgang 3 der ersten Teilerschaltung 1 auftretenden Schwingungszüge vom Rechner gezählt. Sie werden dann mit ganzzahligen Werten von Schwingungszügen des Signals entsprechend dem gebrochenzahligen Anteil ins Verhältnis gesetzt. Es werden also Zähler und Nenner des gebrochenzahligen Anteils so erweitert, daß sie sich mit ganzzahligen Werten von Schwingungszügen des Signals decken.

Dann wird während der Dauer der dem Zähler des gebrochenzahligen Anteils entsprechenden Schwingungszüge der ganzzahlige Anteil des Teilerverhältnisses um "eins" erhöht und anschließend erniedrigt und zwar bis zum Ende der dem Nenner des gebrochenzahligen Anteils entsprechenden Schwingungszüge. Anschließend wird das Teilerverhältnis wieder um "eins" erhöht. Dieser Vorgang läßt sich auch durch einfache Programmbefehle ausführen, so daß ebenfalls ein Hin- und Herpendeln des Teilerverhältnisses und damit der Frequenz des Signals am Ausgang 3 erreicht wird.

Bei Anwendungsfällen, die keine Variation über den gesamten möglichen Bereich des Teilerverhältnisses erfordern, kann es auch ausreichen, das ganzzahlige Teilerverhältnis einzuschränken und stattdessen einen konstanten Vorteiler vorzusehen. Soll der programmierbare Frequenzteiler für eine noch höhere Frequenzauflösung ausgebildet werden, so können statt der dreistelligen Ausbildung der zweiten Teilerschaltung 5 sowie des Komparators 16 auch Baugruppen verwendet werden, die vier oder mehrstellig ausgebildet sind.

## Patentansprüche

1. Programmierbarer Frequenzteiler für ganzzahlige Teilerverhältnisse, bestehend aus einer ersten Teilerschaltung (1), an deren Eingang (2) ein Signal hoher Frequenz anlegbar und an deren Ausgang (3) ein Signal einer heruntergeteilten, niedrigen Frequenz abgreifbar ist, mit einem Steuereingang (4) zur Vorgabe eines Teilerverhältnisses, aus einer zweiten Teilerschaltung (5), deren Eingang (6) am Ausgang (3) der ersten Teilerschaltung (1) liegt, und aus einem Flip-Flop (8), dessen Eingang (9) mit dem Ausgang (7) der zweiten Teilerschaltung (5) und dessen Ausgang (11) mit dem Steuereingang (4) der ersten Teilerschaltung (1) verbunden ist, **dadurch gekennzeichnet**, daß der Ausgang (11) des Flip-Flops (8), das als einflankengetriggertes Flip-Flop (8) dient, mit dem Steuereingang (4) der ersten Teilerschaltung (1) über einen ganzzahligen Teil des Teilerverhältnisse verändernden Addierer (12) verbunden ist, und daß der Steuereingang (4) der Teilerschaltung (1) zur Vorgabe eines Teils eines mehrstelligen Datenwortes ausgebildet ist, wobei der Ausgang (11) des Flip-Flops (8) der niedrigstwertigen Stelle am Eingang (14) des Addierers (12) zugeordnet ist.

2. Programmierbarer Frequenzteiler für gebrochenzahlige Teilerverhältnisse, bestehend aus einer ersten Teilerschaltung (1), an deren Eingang (2) ein Signal hoher Frequenz anlegbar und anderen Ausgang (3) ein Signal einer heruntergeteilten, niedrigen Frequenz abgreifbar ist, mit einem Steuereingang (4) zur Vorgabe eines Teilerverhältnisse, aus einer zweiten Teilerschaltung (5), deren Eingang (6) am Ausgang (3) der ersten Teilerschaltung (1) liegt, und aus einem Flip-Flop (8), dessen Eingang (9) mit dem Ausgang (7) der zweiten Teilerschaltung (5) und dessen Ausgang mit dem Steuereingang (4) der ersten Teilerschaltung (1) verbunden ist, **dadurch gekennzeichnet**, daß der Ausgang (11) des Flip-Flops (8), das als einflankengetriggertes Flip-Flop (8) dient, mit dem Steuereingang (4) der ersten Teilerschaltung (1) über einen einen ganzzahligen Teil des Teilerverhältnisses verändernden Addierer(12) verbunden ist, und daß der Steuereingang (4) der ersten Teilerschaltung (1) zur Vorgabe eines Teils eines mehrstelligen Datenwortes ausgebildet ist, wobei der Ausgang (11) des Flip-Flops (8) der niedrigstwertigen Stelle am Eingang (14) des Addierers (12) zugeordnet ist, und daß der dynamische Eingang (9) des Flip-Flops (8) mit dem höchstwertigen Bitausgleichsleitung (7, D) des Ausgangs der zweiten Teilerschaltung verbunden ist, daß der Ausgang (7) der zweiten Teilerschaltung (5) an einem ersten Eingang (17) eines Komparators (16) liegt, dessen Paritätsausgang (19) mit einem statischen Eingang (10) des Flip-Flops (8) verbunden ist, und daß ein zweiter Eingang (18) des Komparators(16) zur Vorgabe eines den gebrochenen Teil des Teilerverhältnisses vorgebenden Datenwortes ausgebildet ist.

3. Programmierbarer Frequenzteiler nach Anspruch 1 oder 2, **dadurch gekennzeichnet**, daß der Steuereingang (4) der ersten Teilerschaltung (1) und der zweite Eingang (18) des Komparators (16) gemeinsam zur Vorgabe des das vollständige Teilerverhältis angebenden Datenwortes ausgebildet sind.

4. Programmierbarer Frequenzteiler nach einem oder mehreren der Ansprüche 1 bis 3, **dadurch gekennzeichnet**, daß die zweite Teilerschaltung (5) eine binäre, drei Bit umfassende Teilerschaltung ist.

## Claims

1. Programmable frequency divider for integral divider ratios, comprising a first divider circuit (1), wherein a high-frequency signal can be applied to the input (2) thereof and a signal of a sub-divided low frequency can be tapped at the output (3) thereof, with a control input (4) for predetermining a divider ratio, also comprising a second divider circuit (5), the input (6) of which lies at the output (3) of the first divider circuit (1), and a flipflop (8), the input (9) of which is connected to the output (7) of the second divider circuit (5) whilst the output (11) thereof is connected to the control input (4) of the first divider circuit (1), characterised in that the output (11) of the flipflop (8), which serves as a single-edge-triggered flipflop (8), is connected to the control input (4) of the first divider circuit (1) via an adder (12) which varies an integral part of the divider ratio, and that the control input (4) of the divider circuit (1) is constructed for predetermining a part of a multi-place data item, the output (11) of the flipflop (8) being assigned to the lowest-value place at the input (14) of the adder (12).

2. Programmable frequency divider for fractional divider ratios, comprising a first divider circuit (1) wherein a high-frequency signal can be applied to the input (2) thereof and a signal of a sub-divided low frequency can be tapped at the output (3) thereof, with a control input (4) for predetermining a divider ratio, also comprising a second divider circuit (5), the input (6) of which lies at the output (3) of the first divider circuit (1), and a flipflop (8), the input (9) of which is connected to the output (7) of the second divider circuit (5) whilst the output thereof is connected to the control input (4) of the first divider circuit (1), characterised in that the output (11) of the flipflop (8), which serves as a single-edge-triggered flipflop (8), is connected to the control input (4) of the first divider circuit (1) via an adder (12) which varies an integral part of the divider ratio, and that the control input (4) of the first divider circuit (1) is constructed for predetermining a part of a multi-place data item, the output (11) of the flipflop (8) being assigned to the lowest-value place at the input (14) of the adder (12), and that the dynamic input (9) of the flipflop (8) is connected to the highest-value bit equalisation line (7, D) of the output of the second divider circuit, that the output (7) of the second divider circuit (5) lies at a first input (17) of a comparator (16), the parity output (19) of which is connected to a static input (10) of the flipflop (8), and that a second input (18) of the comparator (16) is constructed for predetermining a data item which predetermines the fractional part of the divider ratio.

3. Programmable frequency divider according to Claim 1 or 2, characterised in that the control input (4) of the first divider circuit (1) and the second input (18) of the comparator (16) are jointly constructed for predetermining the data item which gives the complete divider ratio.

4. Programmable frequency divider according to one or several of Claims 1 to 3, characterised in that the second divider circuit (5) is a binary divider circuit comprising three bits.

## Revendications

1. Diviseur de fréquence programmable pour des rapports de diviseur entiers, constitué par un premier circuit diviseur (1), à l'entrée (2) duquel un signal de fréquence élevée peut être appliqué et à la sortie (3) duquel un signal d'une fréquence basse, qui a été divisée, peut être pris, avec une entrée de commande (4) pour prédéterminer un rapport de diviseur, par un second circuit diviseur (5), dont l'entrée (6) se trouve à la sortie (3) du premier circuit diviseur (1), et par une bascule (8) dont l'entrée (9) est reliée à la sortie (7) du second circuit diviseur (5) et dont la sortie (11) est reliée à l'entrée de commande (4) du premier circuit diviseur (1), **caractérisé en ce** que la sortie (11) de la bascule (8), qui sert de bascule déclenchée par un flanc (8), est reliée à l'entrée de commande (4) du premier circuit diviseur (1) par une partie à nombre entier de l'additionneur (12) qui modifie les rapports de diviseur et que l'entrée de commande (4) du circuit diviseur (1) est configurée pour la prédéfinition d'une partie d'un mot de données à plusieurs positions, la sortie (11) de la bascule (8) étant affectée à la position de poids le plus faible à l'entrée (14) de l'additionneur (12).

2. Diviseur de fréquence programmable pour des rapports de diviseur fractionnaires, constitué par un premier circuit diviseur (1), à l'entrée (2) duquel un signal de fréquence élevée peut être appliqué et à la sortie (3) duquel un signal d'une fréquence basse, qui a été divisée, peut être pris, avec une entrée de commande (4) pour prédéterminer un rapport de diviseur, par un second circuit diviseur (5), dont l'entrée (6) se trouve à la sortie (3) du premier circuit diviseur (1), et par une bascule (8) dont l'entrée (9) est reliée à la sortie (7) du second circuit diviseur (5) et dont la sortie est reliée à l'entrée de commande (4) du premier circuit diviseur (1), **caractérisé en ce** que la sortie (11) de la bascule (8), qui sert de bascule déclenchée par un flanc (8), est reliée à l'entrée de commande (4) du premier circuit diviseur (1) par une partie à nombre entier de l'additionneur (12) qui modifie les rapports de diviseur et que l'entrée de commande (4) du circuit diviseur (1) est configurée pour la prédéfinition d'une partie d'un mot de données à plusieurs positions, la sortie (11) de la bascule (8) étant affectée à la position de poids le plus faible à l'entrée (14) de l'additionneur (12) et que l'entrée dynamique (9) de la bascule (8) est reliée à la ligne d'égalisation de poids le plus significatif (7, D) de la sortie du second circuit diviseur, que la sortie (7) du second circuit diviseur (5) est appliquée à une première entrée (17) d'un comparateur (16) dont la sortie de parité (19) est reliée à une entrée statique (10) de la bascule (8) et qu'une seconde entrée (18) du comparateur (16) est configurée pour la prédéfinition d'un mot de données qui prédéfinit la partie fractionnaire du rapport du diviseur.

3. Diviseur de fréquence programmable selon la revendication 1 ou 2, **caractérisé en ce** que l'entrée de commande (4) du premier circuit diviseur (1) et la seconde entrée (18) du comparateur (16) sont configurées ensemble pour la prédéfinition du mot de données qui indique le rapport de diviseur complet.

4. Diviseur de fréquence programmable selon l'une ou plusieurs des revendications 1 à 3, **caractérisé en ce** que le second circuit diviseur (5) est un circuit diviseur binaire qui comprend trois bits.
